# EUROPÄISCHE PATENTSCHRIFT

(11) **EP 4 240 557 B1**
(45) Veröffentlichungstag und Bekanntmachung des Hinweises auf die Patenterteilung: **15.04.2026**
(21) Anmeldenummer: 21794790.2
(22) Anmeldetag: 15.10.2021
(51) Int. Cl.: B23K 1/00, B23K 1/19, H01L 23/34, B23K 101/14, B23K 101/36, B23K 103/10, B23K 103/12

(54) **VERFAHREN ZUR HERSTELLUNG EINES KÜHLKÖRPERS DURCH HARTLÖTEN**
METHOD FOR PRODUCING A HEATSINK BY BRAZING
PROCÉDÉ DE FABRICATION D'UN DISSIPATEUR THERMIQUE PAR BRASAGE

(30) Priorität: 04.11.2020 DE 102020213850
(43) Veröffentlichungstag der Anmeldung: 13.09.2023
(73) Patentinhaber: Robert Bosch GmbH, 70442 Stuttgart (DE)
(72) Erfinder: WETZL, Franz, 74395 Mundelsheim (DE); LORENZ, Marco, 71254 Ditzingen (DE); JATZEK, Christoph, 72379 Hechingen-Schlatt (DE)
(86) Internationale Anmeldenummer: PCT/EP2021/078582
(87) Internationale Veröffentlichungsnummer: WO 2022/096250

(56) Entgegenhaltungen:
- CN-A- 101 502 904
- JP-A- 2020 131 251
- US-A1- 2013 277 034

## Beschreibung

### Stand der Technik

Die vorliegende Erfindung betrifft ein Verfahren zur Herstellung eines Kühlkörpers für ein Leistungselektronik-Bauelement sowie eine Anordnung umfassend einen derart hergestellten Kühlkörper.

Leistungshalbleiter in der Leistungselektronik führen beispielsweise bei Fahrzeugen mit elektrischem Antrieb oder Hybrid-Fahrzeugen hohe elektrische Ströme. Im Betrieb kann hierbei eine Verlustwärme entstehen, welche nur über sehr kleine Flächen abgeführt werden kann. Hierbei können Wärmestromdichten bis zu 1000 W/cm² erreicht werden. Von daher muss eine Flüssigkühlung vorgesehen werden, um eine Überhitzung beispielsweise eines Steuergeräts des Fahrzeugs, zu vermeiden. Weiterhin muss bei Steuergeräten von Fahrzeugen eine gewisse Robustheit vorliegen, um Temperaturschwankungen, Vibrationen, Schläge oder dgl., ohne Beschädigung im Betrieb überstehen zu können. Daher sind derartige Flüssigkühler häufig als Druckgussbauteile ausgestaltet, wobei diese neben einem hohen Gewicht auch einen relativ großen Herstellungsaufwand aufweisen. Eine Alternative sind aus mehreren Bauteilen hergestellte Aluminiumkühler, wobei für das Fügen des Aluminiums jedoch eine sehr hohe Temperatur in einem Hartlötprozess erforderlich ist, welche das Aluminiummaterial negativ, beispielsweise hinsichtlich eines Verzuges beeinflusst. Ein Problemkreis bei Aluminium als Material für den Kühlkörper ist zudem dadurch gegeben, dass zum Fügen von Leistungselektronik-Bauelementen eine weichlötbare Oberfläche notwendig ist. Häufig wird hier eine Kupferbeschichtung verwendet. Kupfer kann jedoch in einem klassischen Hartlötprozess nicht mit Aluminium verbunden werden, da sich bereits ab 548°C eine niederschmelzende Aluminium-Kupfer-Phase bildet, welche zum Aufschmelzen beider Fügepartner führen kann. Insofern steht hier ein großer Bedarf an einer verbesserten Herstellung derartiger Kühlkörper. Aus der US 2013/277034 A1 ist ein Verfahren zur Herstellung eines Aluminium-Kühlkörpers mit einem spannungsreduzierenden Bauteil und einer Substratschicht bekannt. Ferner offenbart die JP 2020 131251 A ein Verfahren zur Verbindung eines Aluminiumbauteils mit einem Nickel enthaltenden Bauteil.

### Offenbarung der Erfindung

Das erfindungsgemäße Verfahren zur Herstellung eines Kühlkörpers für Leistungselektronik-Bauteile mit den Merkmalen des Anspruchs 1 weist demgegenüber den Vorteil auf, dass wenigstens zwei Bauteile des Kühlkörpers mittels einer Hartlotverbindung mit einem niederschmelzenden Hartlot im Temperaturbereich zwischen 520° bis 540° verbunden sind. Dadurch kann ein Hartlötverfahren angewandt werden, welches unterhalb der kritischen Temperatur von 548°C bleibt, bei welchem ein Aufschmelzen der Fügepartner Aluminium und Kupfer auftreten kann. Somit kann verhindert werden, dass sich eine niederschmelzende Aluminium-Kupfer-Phase bildet, an welcher später ein Leistungselektronik-Bauelement nicht mehr durch einen Weichlötvorgang, welcher deutlich niedrigere Temperaturen unterhalb von 420°C verwendet, fixiert werden. Dies wird erfindungsgemäß dadurch erreicht, dass der Kühlkörper wenigstens zwei Bauteile aufweist, ausgewählt aus: einem Aluminium-Unterteil, einem Aluminium-Oberteil, einem Einleger aus Aluminium und einer Kupferplatte. Dabei sind wenigstens zwei der o.g. Bauteile mittels eines Hartlötverfahrens mit einem niederschmelzenden Hartlot verbunden, wobei die Lötverbindung in einem Temperaturbereich zwischen 520°C bis 540°C hergestellt wird. Dadurch kann sicher ein Aufschmelzen zu der oben erläuterten Aluminium-Kupfer-Phase verhindert werden. Somit weist der Kühlkörper insbesondere eine niederschmelzende Hartlotverbindung zwischen dem Aluminium-Unterteil und der Kupferplatte oder dem Aluminium-Oberteil und der Kupferplatte, auf.

Die Unteransprüche zeigen bevorzugte Weiterbildungen der Erfindung.

Vorzugsweise wird das Hartlötverfahren mit dem niederschmelzenden Hartlot bei einer Temperatur von 530°C ausgeführt. Dadurch ist ein ausreichender Abstand zu der Temperaturgrenze von 548°C vorhanden.

Das niederschmelzende Hartlot umfasst entsprechend der Erfindung Aluminium und Silber und Kupfer und Silizium. Vorzugsweise umfasst das niederschmelzende Hartlot Silizium in einem Bereich von 1 bis 2 Masse-%.

Alternativ und entsprechend der Erfindung umfasst das niederschmelzende Hartlot ausschließlich Aluminium, Silber und Kupfer in einem Verhältnis von 40 Masse-% Aluminium, 40 Masse-% Silber und 20 Masse-% Kupfer.

Besonders bevorzugt wird das erfindungsgemäße Verfahren derart ausgeführt, dass das Aluminium-Unterteil, das Aluminium-Oberteil und der Aluminium-Einleger durch ein Hartlot bei einer Temperatur von ≥ 590°C verbunden wird und anschließend die Kupferplatte mit dem Aluminium-Unterteil oder dem Aluminium-Oberteil mittels des niederschmelzenden Hartlots bei einer Löttemperatur von 520°C bis 540°C verbunden. Somit ist die niederschmelzende Hartlotverbindung an der Kupferplatte ausgebildet. Dadurch weist vorzugsweise der Kühlkörper eine niederschmelzende Hartlotverbindung zur Fixierung der Kupferplatte auf und die anderen Bauteile des Kühlkörpers sind mit einem üblichen Hartlötprozess bei Temperaturen ≥ 590°C ausgeführt. Vorzugsweise wird anschließend ein Leistungselektronik-Bauelement an der Kupferplatte mittels eines Weichlötverfahrens (Temperatur ≤ 420°C) befestigt.

Alternativ wird das erfindungsgemäße Verfahren derart ausgeführt, dass das Aluminium-Unterteil, das Aluminium-Oberteil und der Aluminium-Einleger mittels des niederschmelzenden Hartlots verbunden werden, wobei auf dem Aluminium-Unterteil oder dem Aluminium-Oberteil eine Kupferbeschichtung aufgebracht ist und das Leistungselektronik-Bauelement dann ausschließlich an der Kupferbeschichtung mittels eines Weichlötverfahrens befestigt wird. Somit können alle Bauteile des Kühlkörpers mittels des niederschmelzenden Hartlots miteinander verbunden werden, wobei dann das Leistungselektronik-Bauelement mittels eines Weichlötverfahrens befestigt wird. Alternativ kann statt der Kupferbeschichtung das Aluminium-Unterteil und/oder das Aluminium-Oberteil als kupfer-walzplattiertes Aluminiumblech ausgebildet sein.

Es sei ferner angemerkt, dass selbstverständlich es auch möglich ist, dass der Kühlkörper ein Aluminium-Unterteil, ein Aluminium-Oberteil, ein Aluminium-Einleger und eine Kupferplatte aufweist, wobei alle Bauteile miteinander mittels des niederschmelzenden Hartlots durch einen Hartlötvorgang miteinander verbunden werden.

Zur Befestigung des Leistungselektronik-Bauelements ist vorzugsweise ein Weichlot in gedruckter Form am Leistungselektronik-Bauelement angeordnet oder alternativ ist eine Weichlötfolie am Leistungselektronik-Bauelement angeordnet, um den Weichlötvorgang auszuführen.

Weiter bevorzugt ist eine Dicke der Kupferplatte kleiner als eine Dicke des Aluminium-Unterteils oder des Aluminium-Oberteils. Die Kupferplatte weist vorzugsweise eine Dicke von ca. 1,5 mm auf und das Aluminium-Unterteil oder das Aluminium-Oberteil weist vorzugsweise eine Dicke von 2,5 mm auf.

Ferner betrifft die vorliegende Erfindung eine Leistungselektronik-Anordnung umfassend ein Leistungselektronik-Bauteil und einen Kühlkörper zur Flüssigkühlung aus Aluminium, welcher ein Aluminium-Unterteil, ein Aluminium-Oberteil, einen Aluminium-Einleger und eine Kupferplatte umfasst, wobei wenigstens eine Verbindung zwischen den Bauteilen des Kühlkörpers durch eine Hartlotverbindung mit einem niedrigschmelzenden Lot mit einer Löttemperatur von ca. 530°C ist oder wobei der Kühlkörper ein Aluminium-Unterteil, ein Aluminium-Oberteil, einen Aluminium-Einleger und eine Kupferbeschichtung auf dem Aluminium-Unterteil und/oder auf dem Aluminium-Oberteil aufweist und eine Bauteilverbindung zwischen den Bauteilen des Kühlkörpers mittels eines niedrigschmelzenden Hartlots mit einer Löttemperatur von ca. 530°C oder einem Schmelzbereich zwischen 490 bis 506°C ausgebildet ist.

### Zeichnung

Nachfolgend werden bevorzugte Ausführungsbeispiele der Erfindung unter Bezugnahme auf die begleitende Zeichnung im Detail beschrieben. In der Zeichnung ist:
- Figur 1: eine schematische Ansicht einer Leistungselektronik-Anordnung mit einem Kühlkörper,
- Figur 2: eine schematische Ansicht einer Leistungselektronik-Anordnung mit einem Kühlkörper, welcher gemäß einem ersten bevorzugten Ausführungsbeispiel der Erfindung hergestellt wurde, und
- Figur 3: eine schematische Ansicht einer Leistungselektronik-Anordnung mit einem Kühlkörper, welcher gemäß einem zweiten bevorzugten Ausführungsbeispiel der Erfindung hergestellt wurde.

### Bevorzugte Ausführungsformen der Erfindung

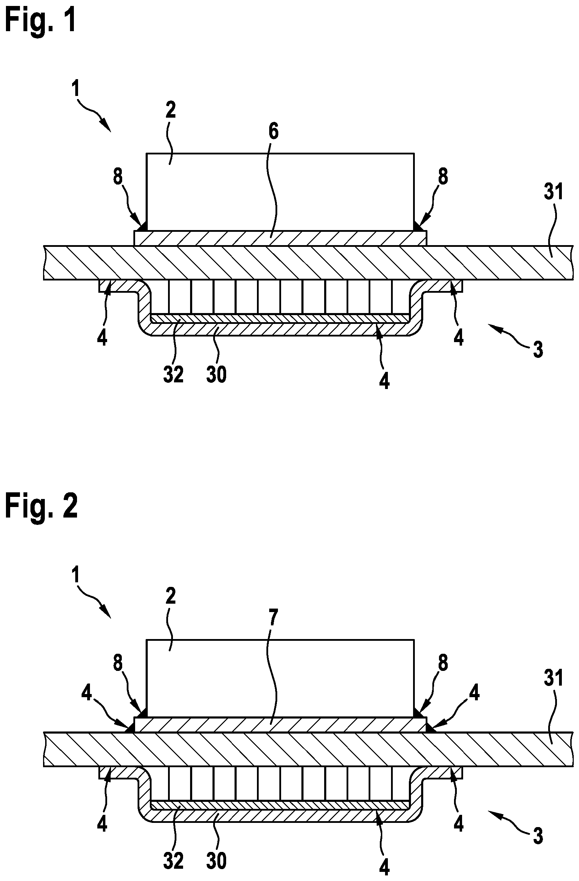

Nachfolgend wird unter Bezugnahme auf die Figur 1 eine Leistungselektronik-Anordnung 1 und ein Verfahren zur Herstellung eines Kühlkörpers im Detail beschrieben.

Wie aus Figur 1 ersichtlich ist, umfasst die Leistungselektronik-Anordnung 1 ein Leistungselektronik-Bauelement 2 mit einem Kühlkörper 3. Der Kühlkörper 3 umfasst ein Aluminium-Unterteil 30, ein Aluminium-Oberteil 31 und ein Aluminium-Einlegeteil 32. Das Aluminium-Einlegeteil 32 ist beispielsweise ein Strip-Fin-Einlegeteil.

Wie aus Figur 1 ersichtlich ist, ist der Kühlkörper 3 unmittelbar unterhalb des Leistungselektronik-Bauelements 2 angeordnet. Der Kühlkörper 3 ist eingerichtet, um mit einer Kühlflüssigkeit für eine verbesserte Kühlwirkung durchströmt zu werden. Hierzu ist am Kühlkörper 3 ein Einlass und ein Auslass (beide nicht gezeigt) zum Zuführen und Abführen der Kühlflüssigkeit vorgesehen. Es sei angemerkt, dass das Aluminium-Einlegeteil auch beispielsweise ein Einlegeteil zur mäanderförmigen Flüssigkeitsführung sein kann.

Wie weiter aus Figur 1 ersichtlich ist, ist an einer Außenfläche des Aluminium-Oberteils 31 eine Kupferbeschichtung 6 vorgesehen. Dadurch ist es möglich, dass das Leistungselektronik-Bauelement 2 mittels einer Weichlotverbindung 8 mit dem Aluminium-Oberteil 31 verbindbar ist.

Weiterhin ist, wie aus Figur 1 ersichtlich ist, zwischen dem Aluminium-Unterteil 30 und dem Aluminium-Einlegeteil 32 eine niederschmelzende Hartlotverbindung 4 ausgebildet. Eine derartige niederschmelzende Hartlotverbindung 4 ist ferner ebenfalls zwischen dem Aluminium-Unterteil 30 und dem Aluminium-Oberteil 31 ausgebildet.

Somit sind bei diesem Ausführungsbeispiel die ansonsten mittels Hartlotverbindungen mit Temperaturen ≥ 590°C vorgesehenen Lötverbindungen des Kühlkörpers 3 durch niederschmelzende Hartlotverbindungen 4 ersetzt, welche bei Temperaturen von ca. 530°C ausgeführt werden. Hierbei ist das niederschmelzende Hartlot eine Legierung, umfassend Aluminium, Silber, Kupfer und Silizium.

Die Kupferbeschichtung 6 kann beispielsweise mittels eines Kaltgasverfahrens auf die Oberfläche des Aluminium-Oberteils 31 aufgebracht werden. Eine Dicke der Kupferbeschichtung 6 ist vorzugsweise ca. 100 µm.

Somit kann ein Kühlkörper 3 aus Aluminium bereitgestellt werden, welcher bei Temperaturen deutlich unterhalb der kritischen Temperatur von 548°C hartgelötet werden kann und trotzdem eine Kupferbeschichtung auf einem Aluminium-Bauteil aufweisen kann, welche trotz des Hartlötvorgangs keine unerwünschte Aluminium-Kupfer-Phase bildet. Dies hat insbesondere den Vorteil, dass ein Aluminium-Bauteil verwendet werden kann, welches schon vor einem Lötverbindungsvorgang die Kupferbeschichtung 6 aufweist. Dies hat ferner insbesondere fertigungstechnische Vorteile. Es sei angemerkt, dass alternativ statt der Kupferbeschichtung auch ein mit Kupfer walzplattiertes Aluminiumblech verwendet werden kann, welches ebenfalls schon vor dem Lötverbindungsvorgang hergestellt werden kann. Weiterhin kann durch die Kupferbeschichtung 6 auch eine hervorragende thermische Anbindung des Leistungselektronik-Bauelements 2 an den Kühlkörper 3 ermöglicht werden.

Nachfolgend wird unter Bezugnahme auf die Figur 2 eine Leistungselektronik-Anordnung 1 und ein Verfahren zur Herstellung eines Kühlkörpers gemäß einem zweiten Ausführungsbeispiel der Erfindung im Detail beschrieben.

Figur 2 entspricht im Wesentlichen der Figur 1, wobei im Unterschied zur Figur 1 beim ersten Ausführungsbeispiel statt der Kupferbeschichtung 6 eine Kupferplatte 7 vorgesehen ist. Wie aus Figur 2 ersichtlich ist, ist die Kupferplatte 7 mittels einer niederschmelzenden Hartlotverbindung 4 mit dem Aluminium-Oberteil 31 verbunden. Das Leistungselektronik-Bauelement 2 ist dann mittels einer Weichlotverbindung 8 mit der Kupferplatte 7 verbunden.

Somit sind beim ersten Ausführungsbeispiel alle Bauteile des Kühlkörpers 3, nämlich das Aluminium-Unterteil 30, das Aluminium-Oberteil 31, das Aluminium-Einlegeteil 32 und die Kupferplatte 7 mittels niederschmelzenden Hartlotverbindungen 4 miteinander verbunden. Dadurch ist eine thermische Belastung des Kühlkörpers 3 bei seiner Herstellung deutlich reduziert, dass der Kühlkörper 3 keinen herstellungsbedingten thermischen Verzug aufweist. Dadurch kann eine Genauigkeit des Kühlkörpers 3 im Vergleich mit dem Stand der Technik signifikant verbessert werden. Ansonsten entspricht dieses Ausführungsbeispiel dem ersten Ausführungsbeispiel, so dass auf die dort gegebene Beschreibung verwiesen werden kann.

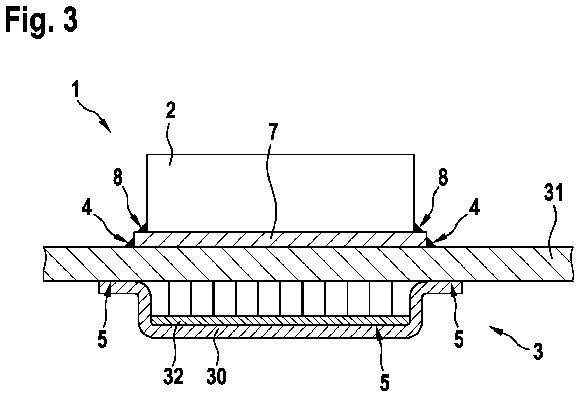

Nachfolgend wird unter Bezugnahme auf die Figur 3 eine Leistungselektronik-Anordnung 1 und ein Verfahren zur Herstellung eines Kühlkörpers gemäß einem zweiten Ausführungsbeispiel der Erfindung im Detail beschrieben.

Wie aus Figur 3 ersichtlich ist, weist das zweite Ausführungsbeispiel ähnlich wie das erste Ausführungsbeispiel ebenfalls eine Kupferplatte 7 auf. Allerdings ist beim zweiten Ausführungsbeispiel zwischen dem Aluminium-Unterteil 30, dem Aluminium-Einlegeteil 32 und dem Aluminium-Oberteil 31 jeweils eine normale Hartlotverbindung 5 vorgesehen, die bei Temperaturen ≥ 590°C hergestellt wird. Die Kupferplatte 7 ist hingegen mittels einer niederschmelzenden Hartlotverbindung 4 mit dem Aluminium-Oberteil 31 bei einer Löttemperatur von ca. 530°C verbunden. Somit kann der Kühlkörper 3 ohne die Kupferplatte 7 mittels der herkömmlichen Hartlotverbindungen 5 verbunden werden. Nachdem diese Vorbaugruppe des Kühlkörpers 3 hergestellt ist, kann dann die Kupferplatte 7 mittels eines niederschmelzenden Hartlotes bei Temperaturen von ca. 530°C auf das Aluminium-Oberteil 31 aufgebracht werden. Anschließend kann dann, wie beim ersten Ausführungsbeispiel, das Leistungselektronik-Bauelement 2 auf die Kupferplatte 7 mittels einer Weichlotverbindung 8 fixiert werden. Ansonsten entspricht dieses Ausführungsbeispiel den vorhergehenden Ausführungsbeispielen, so dass auf die dort gegebene Beschreibung verwiesen werden kann.

Somit ermöglicht die Erfindung durch Verwendung eines niederschmelzenden Hartlotes, welches insbesondere einen Schmelzbereich zwischen 490 bis 506°C aufweist, eine deutliche Verbesserung bei der Herstellung des Kühlkörpers 3, wie in den zwei Ausführungsbeispielen dargelegt. Dabei kann einerseits nur eine einzige niederschmelzende Hartlotverbindung 4 zwischen zwei Bauteilen des Kühlkörpers 3 vorgesehen werden, oder alternativ werden mehr als zwei oder alle Bauteile des Kühlkörpers 3 durch eine niederschmelzende Hartlotverbindung 4 miteinander verbunden. Den beiden Herstellungsverfahren ist dabei gemeinsam, dass keine unerwünschte Aluminium-Kupfer-Phase auftritt, da es für den Weichlotvorgang zur Fixierung des Leistungselektronik-Bauelements 2 auf dem Aluminium-Kühlkörper 3 notwendig ist, Kupfer aufzubringen, da das Leistungselektronik-Bauelement 2 nicht direkt auf Aluminium mittels eines Weichlötvorgangs fixiert werden kann.

Somit kann der Kühlkörper 3, wie in den zwei Ausführungsbeispielen dargestellt, einen Aufbau aus Aluminium und Kupfer aufweisen, wodurch eine deutlich bessere thermische Leistungsfähigkeit des Kühlkörpers 3 erreicht wird. Insbesondere ermöglicht die Erfindung auch eine Variation der notwendigen Kupferfläche hinsichtlich ihrer Länge, Breite und Höhe. Hierbei muss auch nicht der Fertigungsprozess umgestellt werden. Falls notwendig, kann erfindungsgemäß trotzdem ein Kühlkörper in seiner Grundform durch einen Aluminium-Aluminium-Hartlötvorgang bei Temperaturen von über 590°C ausgeführt werden und anschließend die Kupferplatte 7 mittels der niederschmelzenden Hartlotverbindung 4 am Kühlkörper bei einer Temperatur von ca. 530°C befestigt werden.

## Patentansprüche

1. Verfahren zur Herstellung eines Kühlkörpers (3) zur Flüssigkeitskühlung von Leistungselektronik-Bauelementen (2), wobei der Kühlkörper (3) wenigstens zwei Bauteile aufweist:
- ein Aluminium-Unterteil (30),
- ein Aluminium-Oberteil (31),
- oder ein Aluminium-Einlegeteil (32)
und eine Kupferplatte (7),
- wobei wenigstens zwei Bauteile mittels eines Hartlötverfahrens mit einem niederschmelzenden Hartlot verbunden werden, wobei das Hartlötverfahren bei einer Temperatur zwischen 520°C und 540°C durchgeführt wird, um zwischen den wenigstens zwei Bauteilen eine niederschmelzende Hartlotverbindung (4) auszubilden, wobei das niederschmelzende Hartlot Aluminium und Silber und Kupfer und Silizium umfasst, oder wobei das niederschmelzende Hartlot ausschließlich Aluminium, Silber oder Kupfer umfasst, insbesondere in einem Verhältnis von 40 Masse-% Aluminium, 40 Masse-% Silber und 20 Masse-% Kupfer, wobei der Kühlkörper (3) eine niederschmelzende Hartlotverbindung zwischen dem Aluminium-Unterteil (30) und der Kupferplatte (7), oder dem Aluminium-Oberteil (31) und der Kupferplatte (7), aufweist.

2. Verfahren nach Anspruch 1, wobei die Temperatur zur Durchführung des Hartlötverfahrens 530°C beträgt.

3. Verfahren nach einem der vorhergehenden Ansprüche, wobei alle Bauteile des Kühlkörpers (3) mittels des niederschmelzenden Hartlots miteinander verbunden sind.

4. Verfahren nach einem der Ansprüche 1 bis 2, wobei der Kühlkörper (3) als Bauteile das Aluminium Unterteil (30), das Aluminium-Oberteil (31) und den Aluminium-Einleger (32) und die Kupferplatte (7) aufweist, und das Aluminium-Unterteil (30), das Aluminium-Oberteil (31) und der Aluminium-Einleger (32) mittels einer Hartlotverbindung (5) durch ein Hartlot bei einer Hartlöttemperatur von ≥ 590°C verbunden sind und anschließend die Kupferplatte (7) mit dem Aluminium-Unterteil (30) oder dem Aluminium-Oberteil (31) mittels der niederschmelzenden Hartlotverbindung (4) verbunden wird.

5. Verfahren nach einem der vorhergehenden Ansprüche, wobei das Leistungselektronik-Bauelement (2) mittels eines Weichlötverfahrens an der Kupferplatte (7) fixiert wird.

6. Verfahren nach Anspruch 5, wobei ein Weichlot in gedruckter Form am Leistungselektronik-Bauelement (2) angeordnet ist oder wobei eine Weichlotfolie am Leistungselektronik-Bauelement (2) angeordnet ist.

7. Leistungselektronik-Anordnung umfassend:
- ein Leistungselektronik-Bauelement (2) und
- einen Kühlkörper (3) zur Flüssigkeitskühlung, wobei der Kühlkörper (3) aus mehreren Bauteilen aus Aluminium und einer Kupferplatte (7) hergestellt ist,
- wobei die Kupferplatte zwischen dem Leistungselektronik-Bauelement (2) und dem Kühlkörper (3) angeordnet ist, und
- wobei wenigstens eine Bauteilverbindung des Aluminium-Unterteils (30), des Aluminium-Oberteils (31) oder des Aluminium-Einlegeteil (32) mit der Kupferplatte (7) des Kühlkörpers (3) eine niederschmelzende Hartlotverbindung (4) ist, welche mittels eines Hartlötvorgangs bei einer Temperatur in einem Bereich von 520°C bis 540°C, insbesondere bei 530°C, ausgebildet ist, wobei das niederschmelzende Hartlot Aluminium und Silber und Kupfer und Silizium umfasst, oder wobei das niederschmelzende Hartlot ausschließlich Aluminium, Silber oder Kupfer umfasst, insbesondere in einem Verhältnis von 40 Masse-% Aluminium, 40 Masse-% Silber und 20 Masse-% Kupfer.

## Claims

1. Method of producing a heat sink (3) for liquid cooling of power electronics components (2), wherein the heat sink (3) has at least two components:
- an aluminium lower portion (30),
- an aluminium upper portion (31),
- or an aluminium insert portion (32)
and a copper plate (7),
- wherein at least two components are bonded to one another with a low-melting brazing solder by a brazing method, wherein the brazing method is conducted at a temperature between 520°C and 540°C in order to form a low-melting brazing solder bond (4) between the at least two components, wherein the low-melting brazing solder comprises aluminium and silver and copper and silicon, or wherein the low-melting brazing solder comprises exclusively aluminium, silver or copper, in particular in a ratio of 40% by mass of aluminium, 40% by mass of silver and 20% by mass of copper, wherein the heat sink (3) includes a low-melting brazing solder bond between the aluminium lower portion (30) and the copper plate (7), or the aluminium upper portion (31) and the copper plate (7).

2. Method according to Claim 1, wherein the temperature for conducting the brazing method is 530°C.

3. Method according to either of the preceding claims, wherein all components of the heat sink (3) are bonded to one another by the low-melting brazing solder.

4. Method according to either of Claims 1 and 2, wherein the components of the heat sink (3) are the aluminium lower portion (30), the aluminium upper portion (31) and the aluminium insert (32) and the copper plate (7), and the aluminium lower portion (30), the aluminium upper portion (31) and the aluminium insert (32) are bonded by a brazing solder bond (5) by a brazing solder at a brazing temperature of > 590°C, and then the copper plate (7) is bonded to the aluminium lower portion (30) or the aluminium upper portion (31) by the low-melting brazing solder bond (4).

5. Method according to any of the preceding claims, wherein the power electronics component (2) is fixed to the copper plate (7) by a soft soldering method.

6. Method according to Claim 5, wherein a soft solder is arranged in printed form on the power electronics component (2) or wherein a soft solder foil is arranged on the power electronics component (2).

7. Power electronics arrangement comprising:
- a power electronics component (2) and
- a heat sink (3) for liquid cooling, where the heat sink (3) has been produced from a plurality of components of aluminium and a copper plate (7),
- wherein the copper plate is arranged between the power electronics component (2) and the heat sink (3), and
- wherein at least one component bond of the aluminium lower portion (30), of the aluminium upper portion (31) or of the aluminium insert portion (32) to the copper plate (7) of the heat sink (3) is a low-melting brazing solder bond (4) formed by means of a brazing operation at a temperature within a range from 520°C to 540°C, in particular 530°C, wherein the low-melting brazing solder comprises aluminium and silver and copper and silicon, or wherein the low-melting brazing solder comprises exclusively aluminium, silver or copper, in particular in a ratio of 40% by mass of aluminium, 40% by mass of silver and 20% by mass of copper.

## Revendications

1. Procédé de production d'un dissipateur thermique (3) destiné au refroidissement par liquide de dispositifs électroniques de puissance (2), le dissipateur thermique (3) comportant au moins deux composants :
- une partie inférieure en aluminium (30),
- une partie supérieure en aluminium (31),
- ou une pièce d'insertion en aluminium (32)
et une plaque de cuivre (7),
- au moins deux composants étant reliés au moyen d'un procédé de brasage dur à l'aide d'une brasure dure à bas point de fusion, le procédé de brasage dur étant mis en œuvre à une température comprise entre 520 °C et 540 °C pour former une liaison de brasage dur à bas point de fusion (4) entre lesdits au moins deux composants, la brasure dure à bas point de fusion comprenant de l'aluminium et de l'argent et du cuivre et du silicium, ou la brasure dure à bas point de fusion comprenant exclusivement de l'aluminium, de l'argent ou du cuivre, en particulier dans un rapport de 40 % en masse d'aluminium, 40 % en masse d'argent et 20 % en masse de cuivre, le dissipateur thermique (3) présentant une liaison de brasage dur à bas point de fusion entre la partie inférieure en aluminium (30) et la plaque de cuivre (7), ou entre la partie supérieure en aluminium (31) et la plaque de cuivre (7).

2. Procédé selon la revendication 1, dans lequel la température permettant de mettre en œuvre le procédé de brasage dur est de 530 °C.

3. Procédé selon l'une quelconque des revendications précédentes, dans lequel tous les composants du dissipateur thermique (3) sont reliés entre eux au moyen de la brasure dure à bas point de fusion.

4. Procédé selon l'une quelconque des revendications 1 et 2, dans lequel le dissipateur thermique (3) comporte, en tant que composants, la partie inférieure en aluminium (30), la partie supérieure en aluminium (31) et la pièce d'insertion en aluminium (32) et la plaque de cuivre (7), et la partie inférieure en aluminium (30), la partie supérieure en aluminium (31) et la pièce d'insertion en aluminium (32) sont reliées au moyen d'une liaison de brasage dur (5) par une brasure dure à une température de brasage dur de > 590 °C, puis la plaque de cuivre (7) est reliée à la partie inférieure en aluminium (30) ou à la partie supérieure en aluminium (31) au moyen de la liaison de brasage dur à bas point de fusion (4).

5. Procédé selon l'une quelconque des revendications précédentes, dans lequel le dispositif électronique de puissance (2) est fixé à la plaque de cuivre (7) au moyen d'un procédé de brasage tendre.

6. Procédé selon la revendication 5, dans lequel une brasure tendre est disposée sous forme imprimée sur le dispositif électronique de puissance (2) ou dans lequel une feuille de brasure tendre est disposée sur le dispositif électronique de puissance (2).

7. Ensemble électronique de puissance comprenant :
- un dispositif électronique de puissance (2) et
- un dissipateur thermique (3) destiné au refroidissement par liquide, le dissipateur thermique (3) étant fabriqué à partir d'une pluralité de composants en aluminium et d'une plaque de cuivre (7),
- la plaque de cuivre étant disposée entre le dispositif électronique de puissance (2) et le dissipateur thermique (3), et
- au moins une liaison entre composants de la partie inférieure en aluminium (30), de la partie supérieure en aluminium (31) ou de la pièce d'insertion en aluminium (32) avec la plaque de cuivre (7) du dissipateur thermique (3) étant une liaison de brasage dur à bas point de fusion (4), qui est réalisée au moyen d'un processus de brasage dur à une température dans une plage de 520 °C à 540 °C, en particulier à 530 °C, la brasure dure à bas point de fusion comprenant de l'aluminium et de l'argent et du cuivre et du silicium, ou la brasure dure à bas point de fusion comprenant exclusivement de l'aluminium, de l'argent ou du cuivre, en particulier dans un rapport de 40 % en masse d'aluminium, de 40 % en masse d'argent et de 20 % en masse de cuivre.
